# EUROPEAN PATENT APPLICATION

(11) **EP 1 978 556 A1**
(43) Date of publication of application: **08.10.2008**
(21) Application number: 07707585.1
(22) Date of filing: 29.01.2007
(51) Int. Cl.: H01L 23/12, H01L 21/60, H05K 3/34

(54) **PRINTED-CIRCUIT BOARD, AND METHOD FOR MANUFACTURING THE SAME**

(30) Priority: 27.01.2006 JP 2006019065
(71) Applicant: IBIDEN CO., LTD., Ogaki-shi, Gifu 503-0917 (JP)
(72) Inventor: TANNO, Katsuhiko, Ibi-gun, Gifu 501-0695 (JP); KAWAMURA, Youichirou, Ibi-gun, Gifu 501-0695 (JP)
(74) Representative: Grünecker, Kinkeldey, Stockmair & Schwanhäusser Anwaltssozietät
(86) International application number: PCT/JP2007/051354
(87) International publication number: WO 2007/086551

(57) **Abstract**

Problem: To provide a method of manufacturing a printed wiring board whereby bumps are formed having roughly the same height on connection pads having varying opening diameters in a solder resist.

Means for Solution: The small-diameter bumps having a high height 78S and formed out of the solder balls 77 loaded into the small-diameter openings 71S in the solder resist layer 70 are flattened such that it is the same as that of the solder bumps 78P in the large-diameter openings 71P. Since the solder bumps 78S in the small-diameter openings 71S as the same in solder amount as the solder bumps 78P in the large-diameter openings 71P, there occurs no non-connection at the solder bumps 78S in the small-diameter openings 71S, allowing the connection reliability between the IC chip 90 and the multilayer printed wiring board 10 to be secured.

## Description

### Technical Field:

0001: This invention relates to a printed wiring board which can suitably be used for a package substrate comprising a build-up multilayer wiring board for mounting an IC chip and a method of manufacturing the printed wiring board.

### Technical Background:

0002: Solder bumps are used for an electrical connection between a package substrate and an IC chip. Solder bumps are formed with the following steps.
(1) A step of printing flux on connection pads formed in a package substrate.
(2) A step of loading solder balls on the connection pads with flux printed thereon.
(3) A step of forming solder bumps out of solder balls by reflow.
An IC chip is placed on solder bumps after the solder bumps are formed on a package substrate and the solder bumps and the pads (terminals) on the IC chip are connected by reflow such that the IC chip is mounted on the package substrate. For the above-described step of loading solder balls on connection pads, the printing technology using concurrently a ball arrangement mask and a squeegee illustrated in Laid-Open Patent No. 2001-267731. Patent Document 1: Laid-open patent No. 2001-267731

### Disclosure of the Invention:

### Problems to be Solved by the Invention:

0003: However, small-diameter solder balls end up being smaller than sand grains, and with the method of using concurrently a ball arrangement mask and a squeegee in Laid-Open patent No. 2001-267731 solder balls become deformed by the squeegee, leading to the unevenness of solder balls in height resulting in lower product qualities. Namely, smaller diameters of solder balls mean lower weight ratios to the surface area, giving rise to an adsorption phenomenon of solder balls due to intermolecular force. In accordance with the conventional technology, since solder balls susceptible to aggregation are fed while being in contact with a squeegee, solder balls are damaged resulting in portions thereof missing. When portions of solder balls are missing, it gives rise to the unevenness in height among solder bumps as described in the above since the volume of a solder bump on each of the connection pads varies.

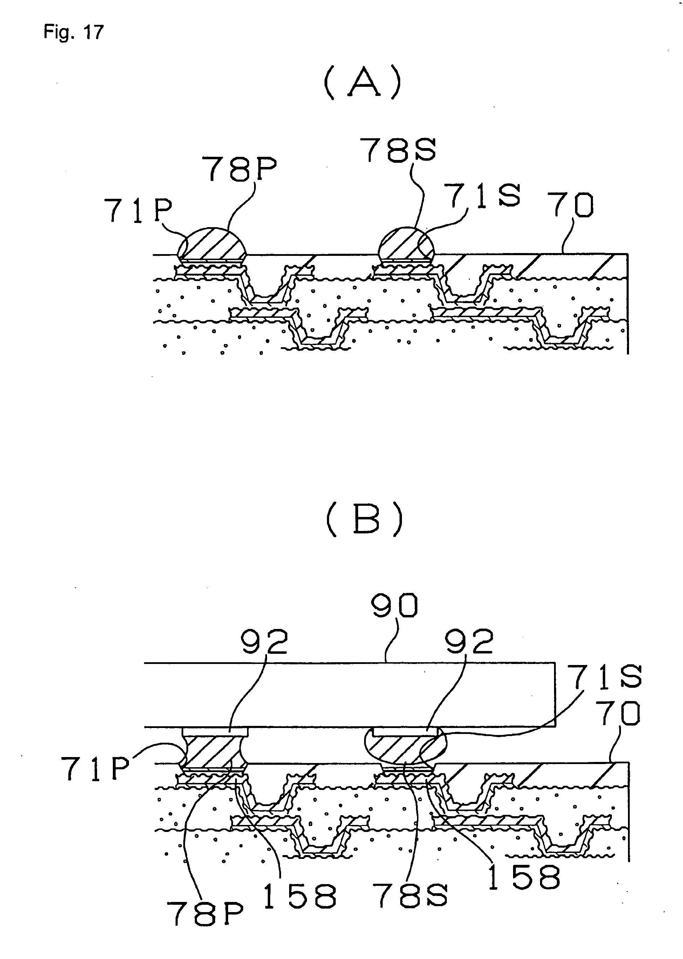

0004: And, with high speed IC chips, there has been a demand for larger diameters for the bumps constituting power supply lines and ground lines so as to be capable of conducting large electrical currents, and, conversely, with highly integrated IC chips there has been a demand for small diameters for the pads and bumps constituting signal lines. Accordingly, the present applicant conducted studies on a provision for power supply and ground of large-diameter opening solder bumps 78P (solder volume being large) in large-diameter openings 71P and on a provision for signal line of small-diameter opening solder bumps 71S (solder volume being small) in the small-diameter openings 71S in the solder resist layer 70, as illustrated in Fig. 17 (A). However, it was learned that with the structure illustrated in Fig. 17 (A), the solder constituting the small-diameter opening solder bump 78S flows out to the pad 92 side on the IC chip 90 when an IC chip is mounted, as illustrated in Fig. 17 (B), such that there occurs a disconnection between the pad 92 on the IC chip and the pad 158 on the printed wiring board.

0005: One of the purposes for the present invention is to provide a printed wiring board and a method of manufacturing the printed wiring board whereby bumps can be formed in roughly the same height on the connection pads (conductor circuits exposed out of the solder resist layer and varying in size) having varying opening diameters in the solder resist. And another purpose is to provide a printed wiring board and a method of manufacturing the printed wiring board having a high mountability yield and connection reliability after the mounting.

### Means to Solve the Problems:

0006: To achieve the above-described purposes, the method of manufacturing a printed wiring board having the bumps as set forth in claim 1 comprises at least the following steps (a) through (c) as technical features;
(a) a step of forming a solder resist layer having small-diameter openings and large-diameter openings exposing connection pads;
(b) a step of loading, with the use of a mask provided with opening portions corresponding to the small-diameter openings and large-diameter openings in the above-described solder resist layer, metal balls having a low melting point in said small-diameter openings and large-diameter openings;
(c) a step of forming by reflow bumps having a high height out of the metal balls having a low melting point in the above-described small-diameter openings and bumps having a low height out of the metal balls having a low melting point in the above-described large-diameter openings; and
(d) a step of pressing from the top on the bumps having a high height in the above-described small-diameter openings such that the height thereof is nearly the same as that of the bumps having a low height in the above-described large-diameter openings.

0007: And, as to the printed wiring board as set forth in claim 3, as to a multilayer printed wiring board wherein on a core substrate having through-hole conductors penetrating the front face and the rear face there are alternately laminated interlayer resin insulating layers and conductor layers, via-hole conductors connect a conductor layer to anther conductor layer, a solder resist layer is provided on the outermost layer, a portion of the conductor layer exposed from an opening in said solder resist layer constitutes a pad to mount an electronic part, and solder bumps are formed on said pads,
the technical features are such that:
the above-described openings are made up with small-diameter openings having a relatively small diameter and large-diameter openings having a relatively large diameter; and
the solder bumps formed in said small-diameter openings and the solder bumps formed in the above-described large-diameter openings are adjusted such that they are approximated to each other in height by the solder bumps formed in the above-described small-diameter openings and in the above-described large-diameter openings having the same volume and by the solder bumps formed in the above-described small-diameter openings being flattened.

0008: In claim 1, with the use of a mask, metal balls having a low melting point are loaded into the large-diameter openings and the small-diameter openings in the solder resist layer. Bumps having a high height are formed out of metal balls having a low melting point in the small-diameter openings in the solder resist layer and bumps having a low height are formed out of metal balls having a low melting point in the large-diameter openings in the solder resist layer. Then, the bumps having a high height in the small-diameter openings are pressed on from the top such that they are made nearly the same in height as the bumps having a low height in the large-diameter openings. Accordingly, even when solder resist opening diameters to expose connection pads vary, bumps can be formed in nearly the same height, and since the bumps in the small-diameter openings have the same amount of the metal having a low melting point as the bumps in the large-diameter openings, there occurs no non-connection at the bumps in the small-diameter openings when an IC chip is loaded via the bumps in the small-diameter openings and the bumps in the large-diameter openings, allowing the connection reliability between the IC chip and the printed wiring board to be secured.

0009: In claim 2, the metal balls having a low melting point are gathered with the use of a mask provided with opening portions corresponding to the openings in the solder resist layer and with a cylinder member being located above said mask and the air being sucked in from said cylinder member, and the metal balls having a low melting point gathered directly below the cylinder member by the above-described cylinder member or the printed wiring board and the mask being moved relative to each other in a horizontal direction are dropped into the small-diameter openings and large-diameter openings of the solder resist layer via the opening portions of the mask. Accordingly, this enables fine metal balls having a low melting point to be loaded with certainty in all the openings of the solder resist layer. And, because the metal balls having a low melting point are moved while not in contact, the metal balls having a low melting point can be loaded in the small-diameter openings and large-diameter openings without being damaged, unlike the case using a squeegee, allowing the height of the bumps to be uniform. Further, this enables metal balls having a low melting point to be properly placed in the openings even on a printed wiring board with a much undulated surface such as a built-up multilayer wiring board.

0010: With the printed wiring board as set forth in claim3, by flattening the solder bumps formed in the small-diameter openings the height of the solder bumps in the small-diameter openings and the height of the solder bumps in the large-diameter openings are approximated to each other with the same volume even though the solder resist openings are different in diameter, and, since the solder bumps in the small-diameter openings have the same volume as the solder bumps in the large-diameter openings, there occurs no non-connection at the solder bumps in the small-diameter openings when an IC chip is loaded via the solder bumps in the small-diameter openings and the solder bumps in the large-diameter openings, allowing the connection reliability between the IC chip and the printed wiring board to be secured.

0011: With the printed wiring board as set forth in claim4, pads for power supply and ground are formed in large-diameter openings and mainly disposed on the center side of the printed wiring board such that the length of the wiring is short resulting in lower resistance value such that the voltage drop is minimized during a sudden increase in power consumption to prevent the IC chip from malfunctioning. Further, by their not being flattened but being maintained in a semi-circle shape, voids can easily be let out in reflow when the IC chip is loaded and the resistance value can be prevented from being elevated due to the voids. Conversely, by forming pads for signal in small-diameter openings, wiring density can be enhanced and concurrently by said small-diameter openings being mainly disposed on the outer side of the large-diameter openings being on the center side, the solder bumps in said small-diameter openings are flattened with a flattening plate material having opening portions corresponding to the sites where the large-diameter openings are formed such that the solder bumps having the same volume and being in the small-diameter openings are approximated in height to the solder bumps in the large-diameter openings to secure connection reliability.

0012: With the printed wiring board as set forth in claim 5, even when solder resist opening diameters vary, by the solder bumps formed in small-diameter openings being flattened, the solder bumps in the small-diameter openings and the solder bumps in large-diameter openings are approximated to the height of 10 µm with the same volume, and since the solder bumps in the small-diameter openings are the same in volume with the solder bumps in large-diameter openings, there occurs no non-connection at the solder bumps in small-diameter openings when an IC chip is loaded via the solder bumps in small-diameter openings and the solder bumps in large-diameter openings allowing the connection reliability between the IC chip and the printed wiring board to be secured.

### Best Modes for Practicing the Invention:

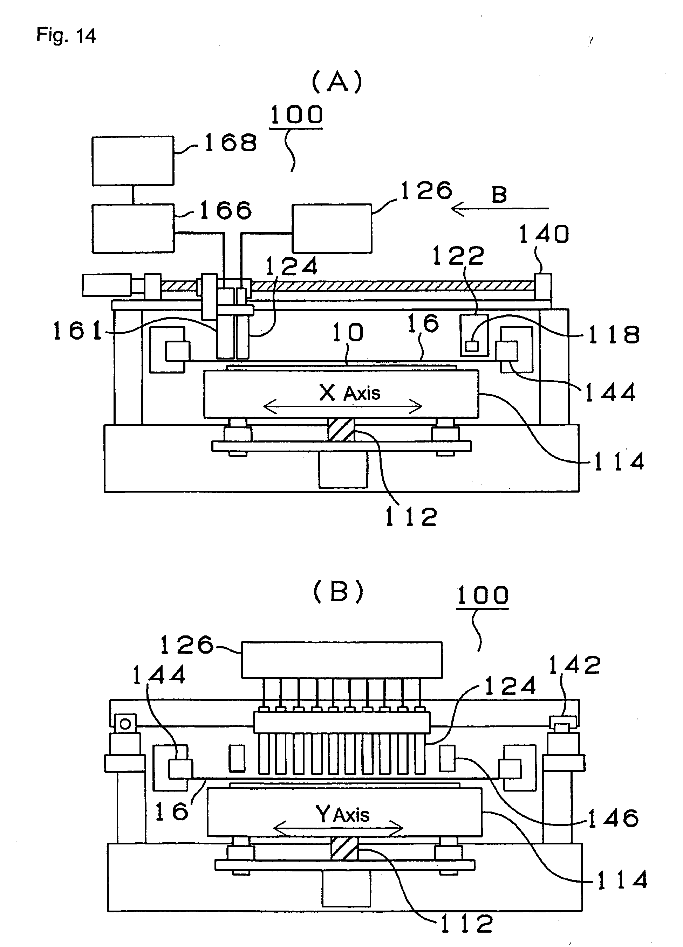

0013: First Example:
Solder Ball Loading Apparatus:
A solder ball loading apparatus for loading very small (less than 200 µm in diameter) solder balls 77 on the connection pads of a multilayer printed wiring board will be described with reference to Fig. 14.
Fig. 14 (A) is a structural diagram illustrating the structure of a solder ball loading apparatus pertaining to one example in accordance with the present invention, and Fig. 14 (B) an arrow directional view of the solder ball loading apparatus in Fig. 14 (A) as viewed from the side of the arrow B.

0014: The solder ball loading apparatus 100 comprises an XY2 suction table 114 for positioning and holding a multilayer printed wiring board 10, a vertically-moving shaft 112 for lifting and lowering said XY2 suction table 114, a ball arrangement mask 16 provided with openings corresponding to the connection pads of the multilayer printed wiring board, a loading cylinder (a cylinder member) 124 for guiding solder balls, a suction box 126 for supplying the loading cylinder 124 with a negative pressure, a ball removing cylinder 161 for collecting excess solder balls, a suction box 166 for supplying said ball removing cylinder 161 with a negative pressure, a ball removing suction unit 168 for holding solder balls collected, a mask clamp 144 for clamping the ball arrangement mask 16, an X-direction-moving shaft for sending the loading cylinder 124 and the ball removing cylinder 161 in the X direction, a moving-shaft support guide 142 for supporting the X-direction-moving shaft 140, an alignment camera146 for photographing the multilayer printed wiring board 10, a remaining amount detecting sensor 118 for detecting the remaining amount of solder balls under the loading cylinder 124, and a solder ball supply unit 122 for supplying solder balls to the side of the loading cylinder 124 based on the remaining amount detected by the remaining amount detecting sensor 118.

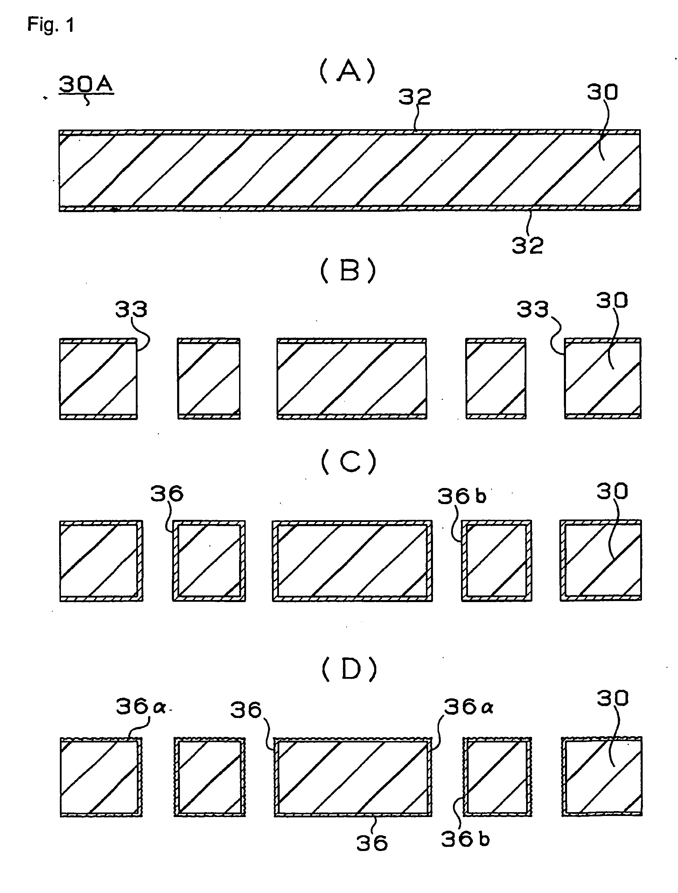

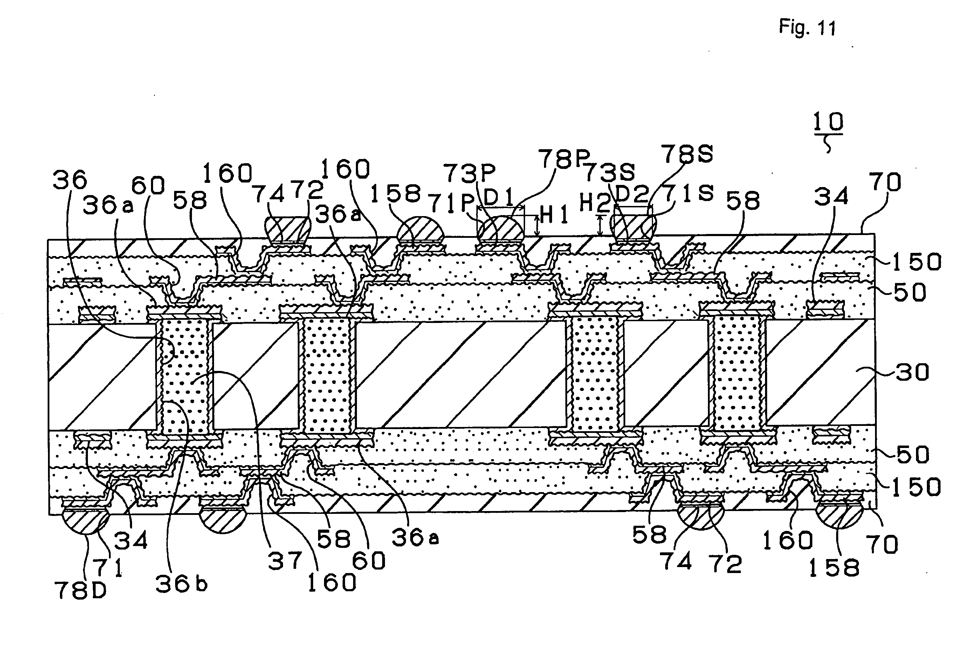

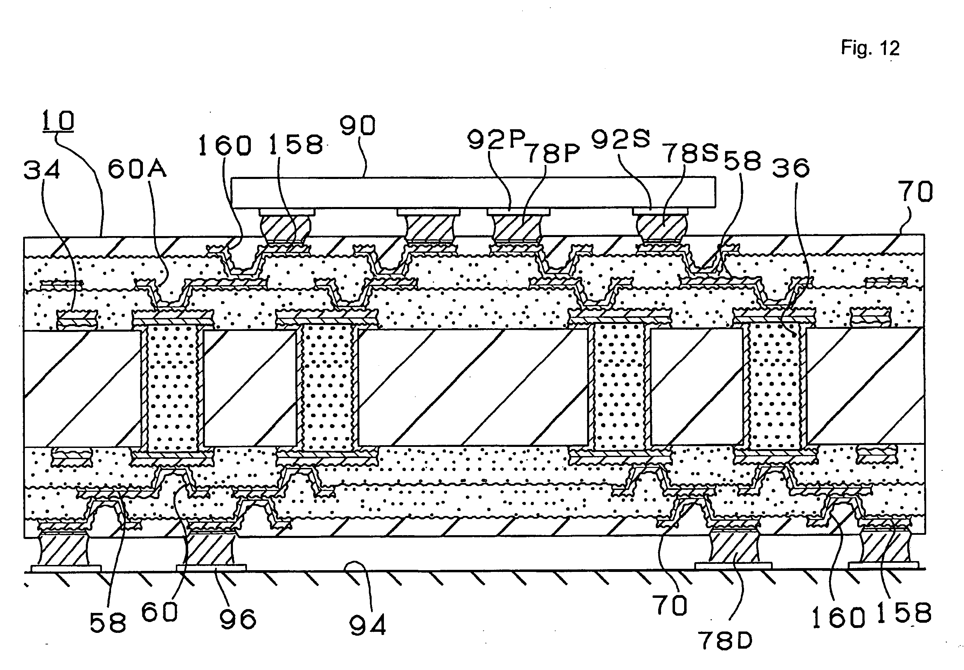

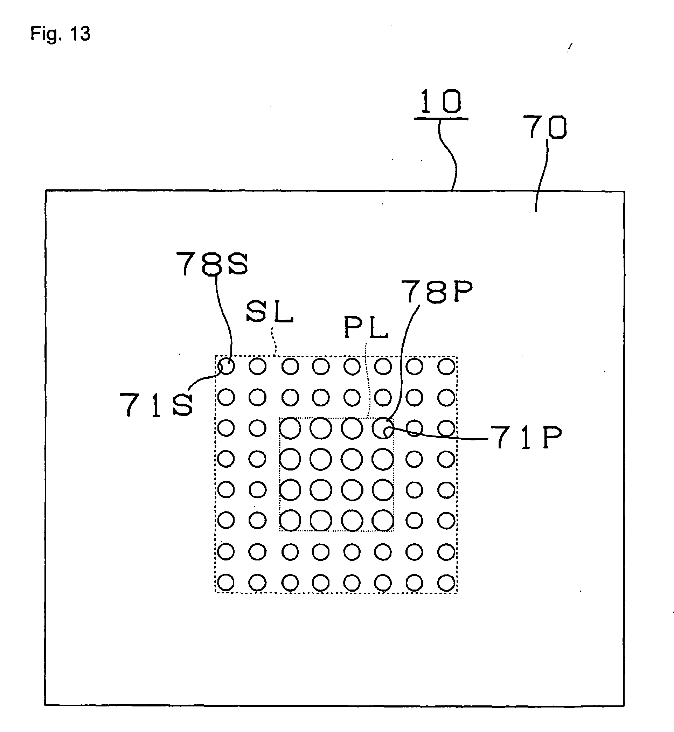

0015: Next, the structure of the multilayer printed wiring board 10 pertaining to the first example in accordance with the present invention will be described with reference to Fig. 1 through Fig. 13. Fig. 11 illustrates a sectional view of said multilayer printed wiring board 10, and Fig. 12 the condition in which the multilayer printed wiring board illustrated in Fig. 11 has an IC chip 90 attached thereto which is placed on a daughter board 94. Fig. 13 illustrates a plan view of the multilayer printed wiring board 10 prior to an IC chip being attached. Here, Fig. 11 and Fig. 12 show illustratively with the numbers of solder bumps 78P and solder bumps 78s illustrated in Fig. 13 being reduced. In addition, on an actual package substrate some hundreds of solder bumps 78P and solder bumps 78S are provided.

0016: As illustrated in Fig. 11, with respect to the multilayer printed wiring board 10, there are formed conductive circuits 34 on the surfaces of a core substrate 30. The top face and the bottom face of the core substrate 30 are connected via through holes 36. On the core substrate 30 there are provided interlayer resin insulating layers 50 having via holes 60 and conductor circuits 58 formed thereon and interlayer resin insulating layers 150 having via holes 160 and conductor circuits 158 formed thereon. On said via holes 160 and conductor circuits 70 there are formed solder resist layers 70. In the solder resist layers 70 there are formed large-diameter (D1=105 µm in diameter) openings 71P and small-diameter (D2=80 µm in diameter) openings 71S, and there are provided solder bumps 78P for power supply and ground on pads 73P in the large-diameter openings 71P and solder bumps 78S for signal on pads 73S in the small-diameter openings 71S. The solder bumps for power supply and ground 78P and the solder bumps for signal 78S are constituted out of solder balls having the same volumetric displacement as described below such that they have the same volume. And, the height H1 of the large-diameter solder bumps 78P is set to about 30 µm and the height H2 of the small-diameter solder bumps 78S is set by being flattened to about 30 µm which is the same as the height of the large-diameter solder bumps 78P. Many of the large-diameter solder bumps for power supply and ground 78P are disposed closer toward the center of the multilayer printed wiring board such that the wiring distance would be short, and the small-diameter solder bumps for signal 78S are disposed relatively lopsidedly on the outer side of the large-diameter solder bumps 78P. On the lower face side of the multilayer printed wiring board there are formed solder bumps 78D via the openings of said solder resist layer 70. In addition, while in Fig. 11 the openings in the solder resist are formed such that a portion of the conductor circuits 158 is exposed, the openings may be formed such that they include via holes 160 only or via holes 160 and a portion of the conductor circuits 158.

0017: As illustrated in Fig. 12, the solder bumps for power supply and ground 78P on the upper face side of the multilayer printed wiring board 10 are connected to the electrodes for power supply and ground 92P of an IC chip 90 and the small-diameter opening solder bumps 78S to the electrodes for ground 92P. Alternately, the solder bumps 78D on the lower face side are connected to the lands 96 of the daughter board 94.

0018: As illustrated in Fig. 13 being a plan view of the multilayer printed wiring board prior to an IC chip being attached, with the multilayer printed wiring board 10 in accordance with the firs example, pads for power supply and ground 73P are formed in large-diameter openings 71P and mainly disposed on the center side (the area inside the dotted lines PL) of the multilayer printed wiring board 10 such that the length of the wiring from the IC chip 90 to the daughter board 94 is short and the resistance value is lowered. By this a drop in supply voltage is minimized when there is a sudden increase in consumed power by the IC chip to prevent the IC chip 90 from malfunctioning. Alternately, wiring density is elevated by pads for signal 73S disposed inside the area indicated by the broken lines SL being formed in the small-diameter openings 71S.

0019: With highly integrated IC chips, there has been a demand for the openings in the solder resist for the signal line of the package substrate to be smaller in diameter and narrower in pitch. Conversely, in order to be able to handle a sudden increase in power consumption by the IC chip, an extremely small diameter of the solder bumps for power supply and ground on the package substrate is not desired. Namely, a small diameter of the solder bumps made of a solder alloy leads to a high resistance value causing a voltage drop when there is a sudden increase in power consumption causing the IC chip to malfunction. A measure to deal with this mutually conflicting demand is for the solder resist openings for signal to be of a small diameter and for the solder bumps for power supply and ground to be not of a small diameter.

0020: Continuing on, the method of manufacturing a multilayer printed wiring board 11 described above with reference to Fig. 11 will be described with reference to Fig. 1 through Fig. 6.
(1) A copper-foiled laminated board 30A wherein a copper foil being 5 to 250 µm is laminated on both faces of an insulation substrate made of a glass-epoxy resin or a BT (bismaleimide triazine) resin 0.2 to 0.8 mm in thickness was used as a starting material (Fig. 1 (A)). First, this copper-clad laminated board was drilled to bore through holes 33 (Fig. 1 (B)), which was electroless-plated and electroplated to form side-wall conductor layers 36b of the through holes 36 (Fig. 1 (C)).

0021: (2) The substrate 30 having through holes 36 formed therein is, after being washed with water and dried, undergoes a blacking process with an aqueous solution containing NaOH (10g/l), NaClO₂ (40g/l), and Na₃PO₄ (6g/l) as a blacking bath (an oxidation bath) and a reduction process with an aqueous solution containing NaOH (10g/l) and NaBH4 (6g/l) as a reduction bath to form roughened faces 36a on the side-wall conductor layers 36b of the through holes 36 and the surfaces (Fig. 1 (D)).

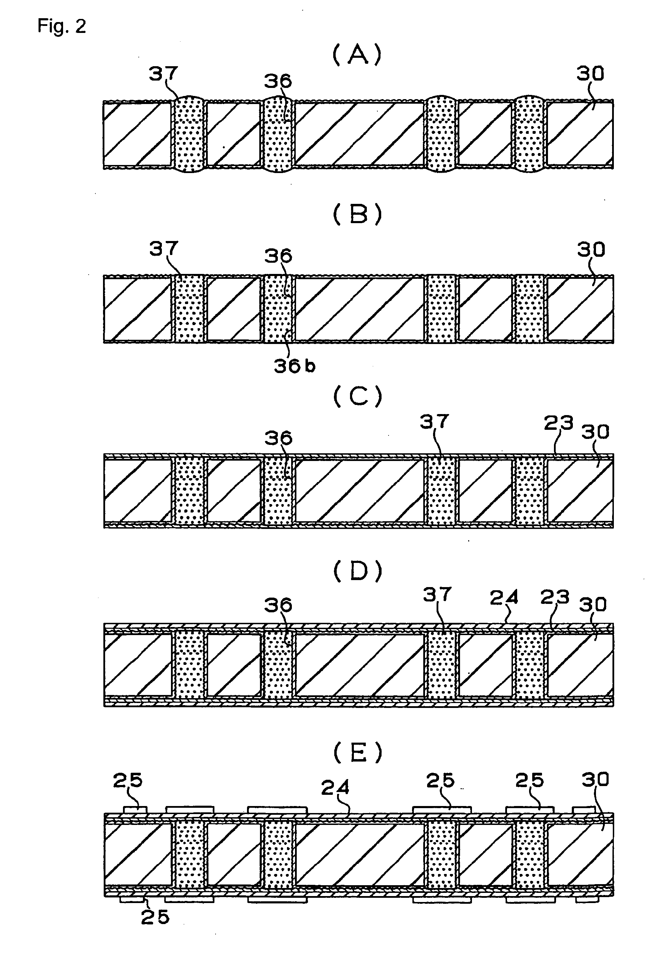

0022: (3) Next, the through holes 36 are filled with a filler 37 containing copper particles of the average particle diameter being 10 µm (a non-conductive plugging copper paste made by Tatsuta Electric Wire & Cable Co., Ltd., Product Name: DD paste) with screen printing, which is dried and hardened (Fig. 2 (A)). This is performed such that a coating is given with a printing method on the substrate with a mask placed thereon and provided with openings at the through hole portions to be filled in the through holes, and following the filling it is dried and hardened.

0023: Continuing on, the filler 36 which oozed out of the through holes 36 is removed by belt-sanding with the use of a #600 belt sanding paper (made by Sankyo Rikagaku Co., Ltd.), and, further, buffed to remove the flaws due to this belt-sanding to level the surfaces of substrate 30 (Fig. 2 (B)). As such, a substrate 30 wherein the side wall conductor layers 36b of the through holes 36 and the resin filler 37 are fixedly adhered via roughened layers 36a.

0024: (4) A palladium catalyst is added to the surfaces of the substrate 30 leveled under the above-described (3) which is electroless copper-plated to form electroless copper-plated films 23 of 0.6 µm in thickness (refer to Fig. 2 (C)).

0025: (5) Then, an electrolytic copper plating is conducted under the following conditions to form electrolytic copper plated films 24 of 15 µm in thickness such that an added thickness for the portions to constitute conductor circuits 34 and the portions to constitute the cover plated layers (through-hole lands) covering the filler 37 filled in through holes 36 are formed (Fig. 2 (D)).

| Electrolytic plating aqueous solution: | | |
|---|---|---|
| | Sulfuric acid | 180 g/l |
| | Copper sulfate | 80 g/l |
| | Additive (made by Atotec Japan, Product name: Caparacid GL) | |
| | | 1 ml/l |
| | | |

| Electrolytic plating conditions: | | |
|---|---|---|
| | Current density | 1 A/dm² |
| | Time | 70 minutes |
| | Temperature | Room temperature. |

0026: (6) On both faces of the substrate 30 with the portions to constitute conductor circuits and cover plated layers formed thereon there are laminated commercially available photosensitive dry films and masks are placed, which is exposed at 100 mJ/cm² and developed with 0.8% sodium carbonate to form etching resists 25 of 15 µm in thickness (refer to Fig. 2 (E)).

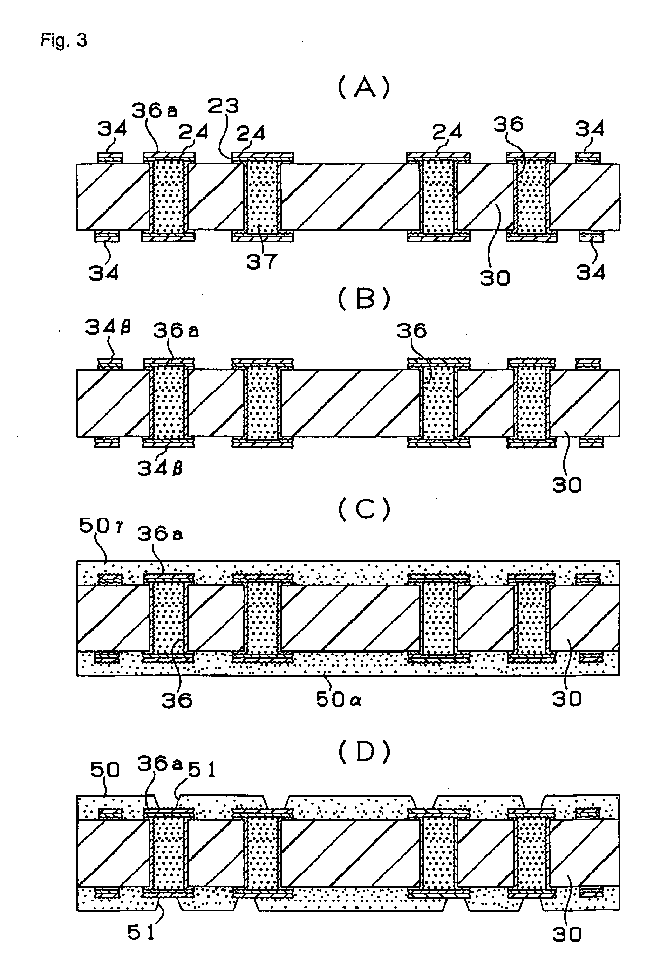

0027: (7) And, the plated films 23, 24 and the copper foils 32 at the portions where the etching resist 25 are not formed are dissolved and removed with an etching solution having cupric chloride as the main ingredient thereof, and, further, the etching resists 25 are stripped and removed with 5% KOH to form independent conductor circuits 34 and the cover plated layers 36a covering the filler 37 (refer to Fig. 3 (A)).

0028: (8) Next, on the surfaces of the cover plated layer 36a covering the conductor circuits 34 and the filler 37 there was formed a roughened layer (an uneven layer) 34β of 2.5 µm in diameter made of a Cu-Ni-P alloy, and, further, on the surface of this roughened layer 34β there was formed an Sn layer of 0.3 µm in thickness (refer to Fig. 3 (B), except, the Sn layer is not illustrated).

0029: (9) On both faces of the substrate there was formed an interlayer resin insulating layer 50, after a resin film for interlayer resin insulating layer (made by Ajinomoto Co., Inc. :Product Name: ABF-45SH) 50γ being slightly larger than the substrate being placed on the substrate and preliminarily pressure-bonded under the conditions of the pressure being 0.45 MPa, the temperature being 80°C, and the pressure-bonding time being 10 seconds and sheared, by being laminated with the use of a vacuum laminator by the following method (Fig. 3 (C)). Namely, the resin film for interlayer resin insulating layer was fully pressure-bonded under the conditions of the degree of vacuum being 67 Pa, the pressure being 0.47 MPa, the temperature being 85°C, and the pressure-bonding time being 60 seconds and subsequently thermoset at 170°C for 40 minutes.

0030: (10) Next, openings for via holes 51 were formed in the interlayer resin insulating layers 50 with a CO2 gas laser at the wavelength of 10.4 µm under the conditions of the beam diameter of 4.00 mm, a top hat mode, the pulse width of 3 to 30 µm, and 1 to 3 shots (Fig. 3 (D)).

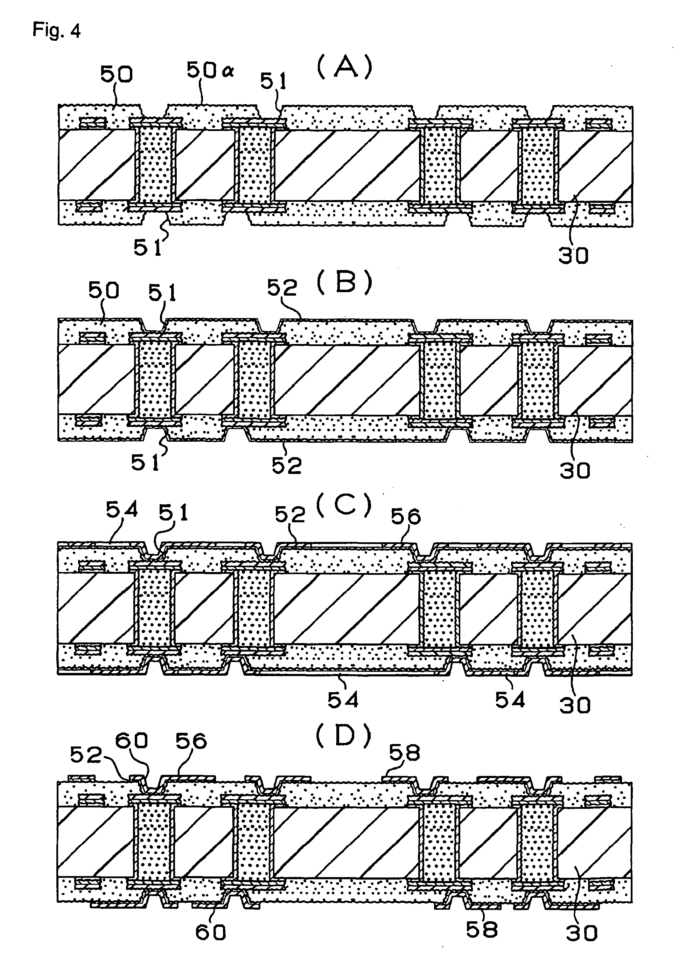

0031: (11) The substrate having the openings 51 for via holes was immersed in a solution containing 60g/l permanganic acid at 80°C for 10 minutes to remove particles present on the surfaces of the interlayer resin insulating layers 50 such that roughened faces 50a were formed on the surfaces of the interlayer resin insulating layers 50 inclusive of the inner walls of the openings for via holes 51 (Fig. 4 (A)).

0032: (12) Next, the above-treated substrate was immersed in a neutralizing solution (made by Shipley Company, LLC) and then washed with water.
Further, to the surfaces of said substrate which have been roughened (roughening depth being 3 µm) a palladium catalyst was added such that the catalyst nucleus was adhered to the surfaces of the interlayer resin insulating layers and the inner wall surfaces of the openings for via holes. Namely, the above-described substrate was immersed in a catalyst solution containing palladium chloride (PbCl₂) and stannous chloride (SnCl₂) to allow palladium metal to deposit such to provide the catalyst.

0033: (13) Next, the substrate provided with the catalyst was immersed in a electroless copper plating aqueous solution (Thrucup PEA) made by Uemura Industries Co., Ltd. to form an electroless copper plated films of 0.3 to 3.0 µm in thickness over the entire roughened surfaces to obtain a substrate wherein electroless copper plated films were formed on the surfaces of the interlayer resin insulating layers 50 inclusive of the inner walls of the openings for via holes 51 (Fig. 4 (B)).
Electroless plating conditions:
Liquid temperature at 34°C for 45 minutes

0034: (14) Commercially available photosensitive dry films were attached to the substrate on which electroless copper plated films 52 had been formed and a mask was placed, which was exposed at 110 mJ/cm² and developed with 0.8% sodium carbonate aqueous solution to provide plating resists 54 of 25 µm in thickness. Then, the substrate was washed with water 50°C to remove grease, and after it was washed with water at 25°C and further washed with sulfuric acid and subsequently it was electroplated under the following conditions to form electrolytic copper plated films 56 of 15 µm in thickness on the portions where the plating resists 54 had not been formed (Fig. 4 (C)).

| Electrolytic plating solution: | | |
|---|---|---|
| | Sulfuric acid | 2.24 mol/l |
| | Copper sulfate | 0.26 mol/l |
| | Additive | 19.5 mol/l |
| | (made by Atotec Japan, Product Name: Caparacid GL) | |
| | | |

| Electrolytic plating conditions: | | |
|---|---|---|
| | Current density | 1 A/dm² |
| | Time | 70 minutes |
| | Temperature | 22 ± 2°C |

0035: (15) Further, after the plating resists 54 being stripped and removed with 5% KOH, the electroless plating films below the plating resists were dissolved and removed by an etching process with a mixture solution of sulfuric acid and hydrogen peroxide to constitute independent conductor circuits 58 and via holes 60 (Fig. 4 (D)).

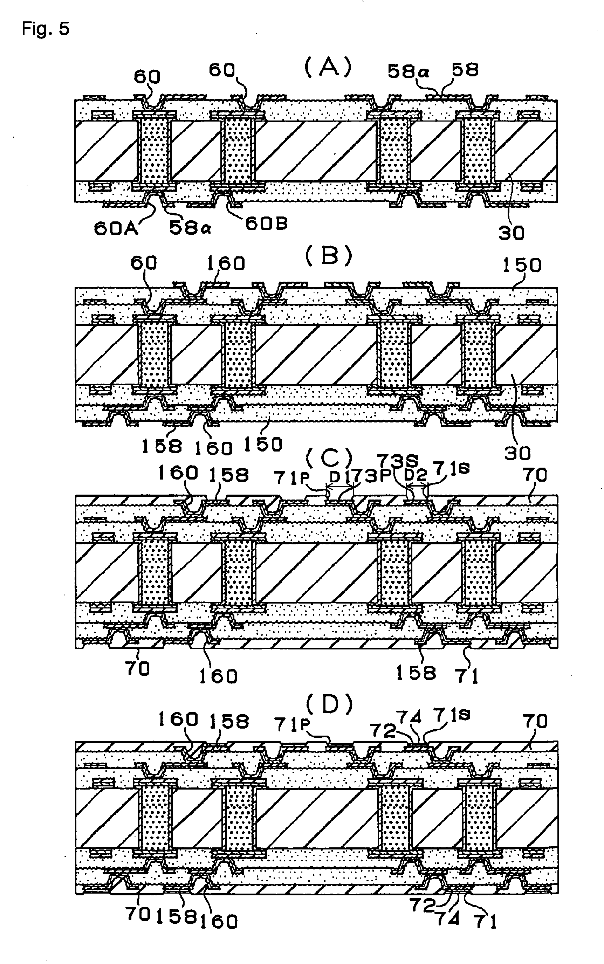

0036: (16) Then, the same processing as in the above-described (4) was conducted to from roughened faces 58a on the surfaces of the conductor circuits 58 and via holes 60. The thickness of the lower layer conductor circuit 58 was 15 µm (Fig. 5 (A)). Except, the lower layer conductor circuit may be formed as having the thickness over the range of 5 to µm.

0037: (17) By repeating the above-described steps (9) through (16), an interlayer insulating layer 150 having upper layer conductor circuits 158 and via holes 160 were further formed to obtain a multilayer wiring board (Fig. 5 (B)).

0038: (18) Next, a commercially available solder resist composition 70 was coated in a thickness of 20 µm on both faces of the multilayer wiring substrate, and after it was dried under the conditions of for 20 minutes at 70°C and then for 30 minutes at 70°C, a photo mask of 5 mm in thickness on which a pattern of the opening portion of the solder resist had been drawn was tightly adhered to the solder resist layer 70, which was exposed to an ultraviolet ray of 1,000 mJ/cm² and developed with a DMTG solution to form large-diameter (D1=105 µmΦ) openings 71P and small-diameter (D2=80 µmΦ) openings 71S on the upper face side, and openings 71 of 200 µm in diameter on the lower face side, and large-diameter pads 73P formed by a portion of the conductor circuits 158 exposed in the large-diameter openings 71P and the small-diameter pads 73S formed by a portion of the conductor circuits 158 exposed in the small-diameter openings 71S were provided (Fig. 5 (C)).
And, further, the solder resist layers were hardened by heat processes under the conditions of for one hour at 80°C, for one hour at 100°C, for one hour at 120°C, and for three hours at 150°C each to form solder resist pattern layers of 15 to 25 µm in thickness having openings.

0039: (19) Next, the substrate on which solder resist layers 70 had been formed was immersed in an electroless nickel plating solution being pH = 4.5 and containing nickel chloride (2.3 × 10⁻¹ mol/l), sodium hypophosphite (2.8 × 10⁻¹ mol/l and sodium citrate (1.6 × 10⁻¹ mol/l) for 20 minutes to form nickel plated layers 72 of about 5 µm in thickness in the openings 71. Further, the substrate was immersed in an electroless gold plating solution containing potassium gold cyanide (7.6 × 10⁻³ mol/l), ammonium chloride (1.9 × 10⁻¹ mol/l sodium citrate (1.2 × 10⁻¹ mol/l), and sodium hypophosphite (1.7 × 10⁻¹ mol/l) under the conditions of for 7.5 minutes at 80°C to form a gold plated layer 74 of about 0.03 µm in thickness on the nickel plated layers 72 (Fig. 5 (D)). Besides a nickel-gold layer, a single layer of tin or a precious metal (gold, silver, palladium, platinum, etc.) may be formed.

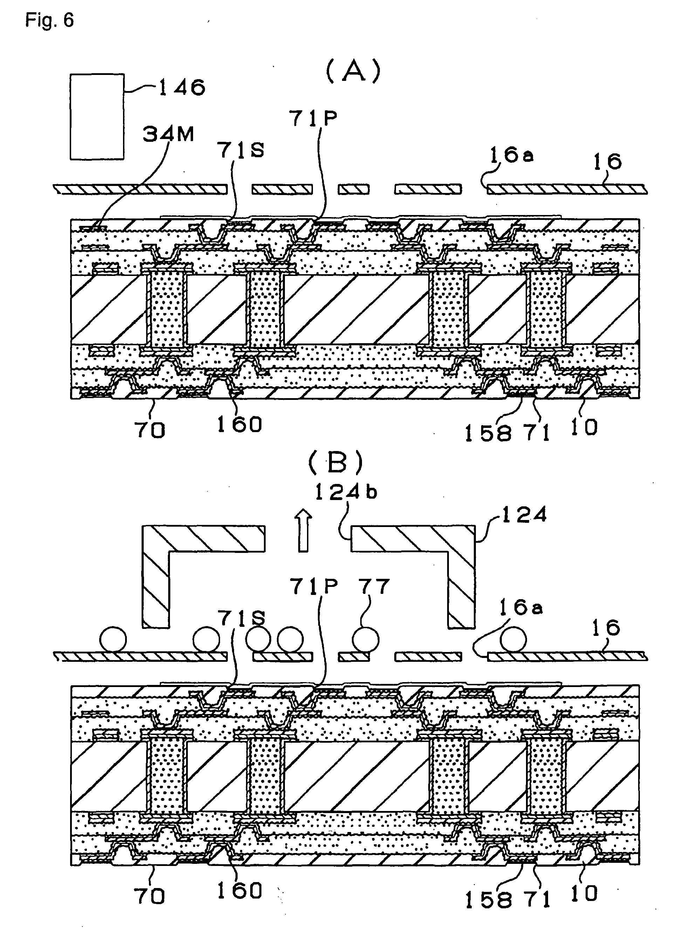

0040: (20) A step of solder ball loading:
Continuing on, a step of loading solder balls onto the multilayer printed wiring board 10 with the solder ball loading apparatus 100 described above with reference to Fig. 14 will be described with reference to Fig. 6 through Fig. 8.

(I) Position recognition and correction of the multilayer printed wiring board:
   The alignment mark 34M of the multilayer printed wiring board 10 is recognized with the alignment camera 146, as illustrated in Fig. 6 (A), such that the position of the multilayer printed wiring board 10 with respect to the ball arrangement mask 16 is corrected with the XY2 suction table 114. Namely, the position is adjusted such that each of the openings 16a of the ball arrangement mask 16 corresponds to each of the small-diameter openings 71S and the large-diameter openings 71P of the multilayer printed wiring board 10.

0041: (II) Supply of solder balls:
As illustrated in Fig. 6 (B), the solder balls 77 (75 µm in diameter, Sn63Pb37 (made by Hitachi Metals, Ltd.)) are supplied in a specified quantity from the solder ball supply unit 122 to the side of the loading cylinder 124. In addition, they may in advance be supplied to be stored in the loading cylinder. While Sn/Pb solder balls were used for solder balls in the examples, they may be Pb-free solder balls selected from a group of Sn and Ag, Cu, In, Bi, Zn, etc.

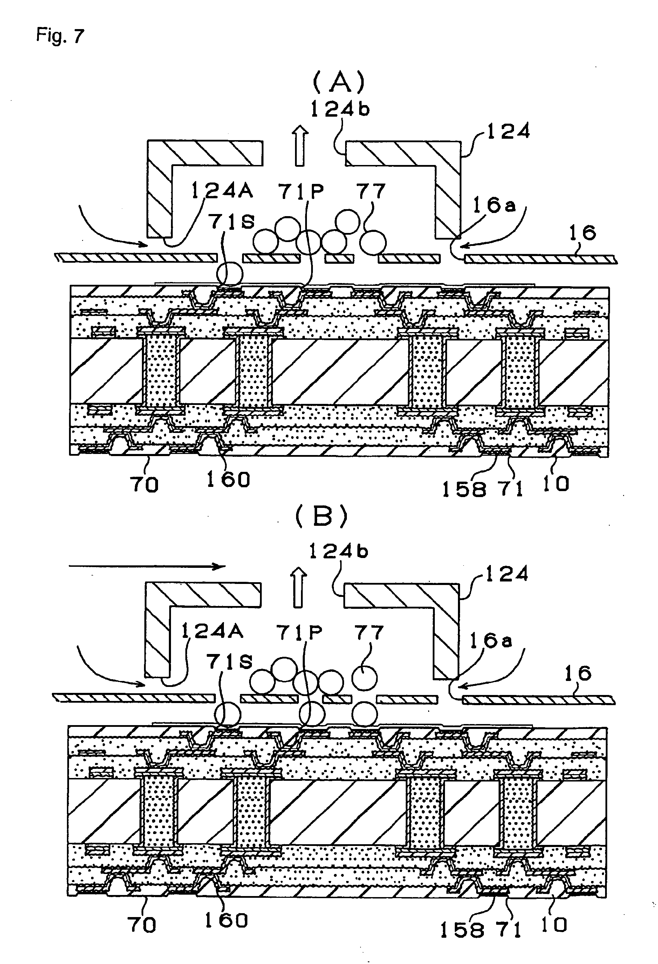

0042: (III) Loading of solder balls:
The loading cylinder 124 was positioned above the ball arrangement mask 16 while maintaining a predetermined clearance (for example, 0.5 to 4 times the ball diameter) to said ball arrangement mask, as illustrated in Fig. 7 (A), and air was suctioned from the suction portion 24b such that the flow velocity at the gap between the loading cylinder and the printed wiring board is set to 5m/sec to 35m/sec to allow the solder balls 77 to gather on the ball arrangement mask 16 directly below the opening portion 124A of said loading cylinder 124.

0043: Subsequently, the loading cylinders 124 lined up along the Y axis of the multilayer wiring board 10 as illustrated in Fig. 7 (B) and Fig. 8 (A) as well as Fig. 14 (B) and Fig. 14 (A) are moved in a horizontal direction along the X axis via the X-direction moving shaft 140. As such, the solder balls 77 gathered on the ball arrangement mask 16 are moved with the movement of the loading cylinders 124 such that they are dropped via the openings 16a of the ball arrangement mask 16 and loaded into the small-diameter openings 71S and the large-diameter openings 71P of the multilayer printed wiring board 10. As such, the solder balls 77 are successively arranged on all the connection pads on the side of the multilayer printed wiring board 10.

0044: Here, while the loading cylinders 124 were moved, it is possible, instead, to move the multilayer printed wiring board 10 and the ball arrangement mask 16 with the loading cylinders 124 being held stationary such that the solder balls 77 gathered directly below the loading cylinders 124 are loaded into the small-diameter openings 71S and the large-diameter openings 71P of the multilayer printed wiring board 10 via the openings 16a of the ball arrangement mask 16.

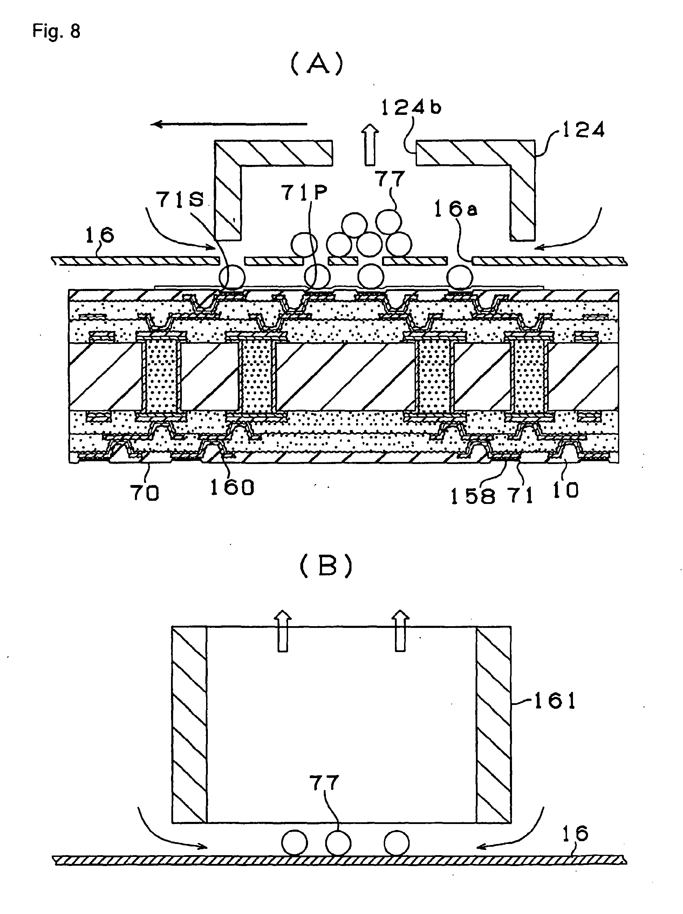

0045: (IV) Removal of adhering solder balls:
As illustrated in Fig. 8 (B), the excess solder balls 77 are guided by the loading cylinders 124 to the locations where there are no openings 16a on the ball arrangement mask 16 to suction out and remove them with the ball removal cylinder 161.

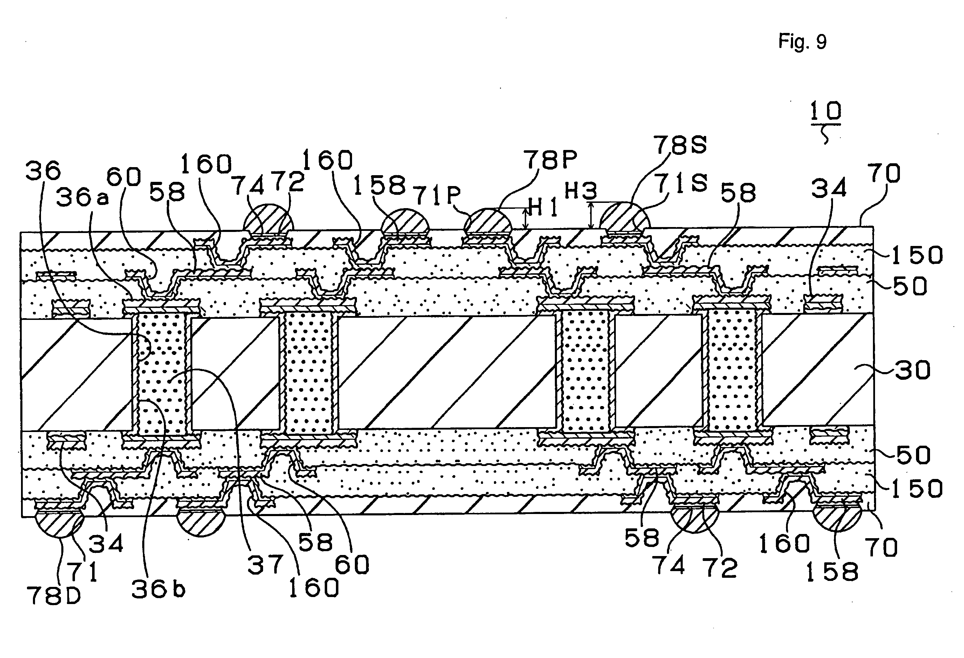

0046: (21) Then, the solder balls 77 on the upper face were melted by reflow at 230°C to form
large-diameter opening solder bumps 78P having a low height (H1®30 µm: the height protruding out of the surface of the solder resist) out of the solder balls 77 in the large-diameter openings 71P and small-diameter opening solder bumps 78S having a high height (H3®40 µm: the height protruding out of the surface of the solder resist) out of the solder balls 77 in the small-diameter openings 71S and solder bumps 78D on the lower face (Fig. 9).

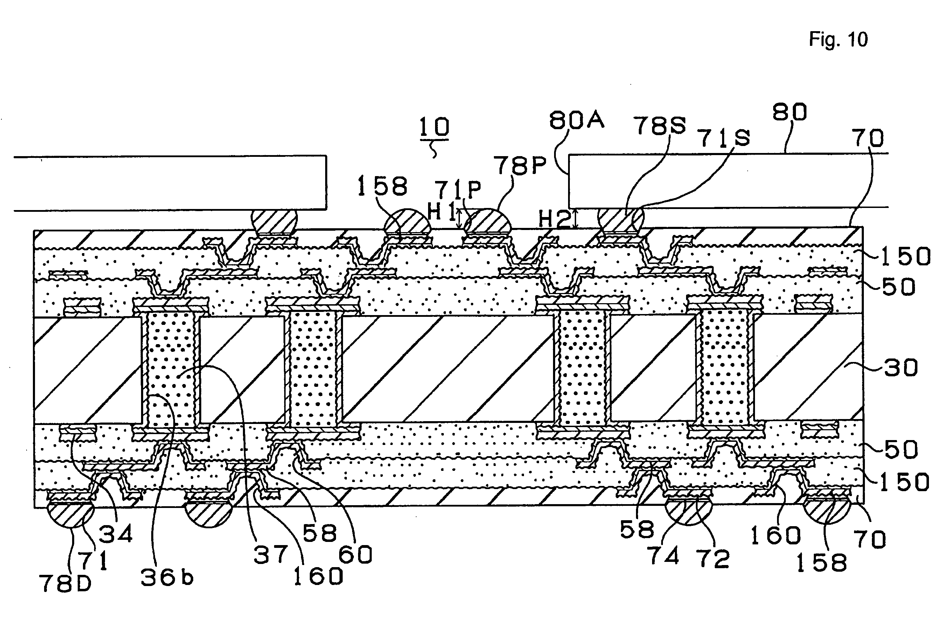

0047: (22) And, as illustrated in Fig. 10, the solder bumps having a high height 78S in the small-diameter openings 71S are flattened by a flat plate 80 having an opening 80A at the position corresponding to the large-diameter opening solder bump portion being pressed on such that it is brought to the same height (H2®30 µm) as the height (H1®30 µm) of the solder bumps 78P in the large-diameter openings 71P (Fig. 11). The flat plate 80 may be heated.

0048: In accordance with the first example, by the small-diameter openings71S being disposed mainly on the outer side of the large-diameter openings 71P being on the center side, the solder bumps in said small-diameter openings 71S are flattened with the flat plate for flattening 80 having an opening 80A corresponding to the position at which the large-diameter openings 71S are disposed such that the solder bumps 78S in the small-diameter openings 71S can be approximated in height to the solder bumps 78P in the large-diameter openings 71P with the same volume.

0049: By the IC chip 90 being loaded onto the multilayer printed wiring board 10 and by reflow the connections pads of the printed wiring board and the electrodes of the IC chip are connected via the solder bumps 78P, 78S. At that juncture, since the solder amount of the solder bumps 78S in the small-diameter openings 71S is the same as that of the solder bumps 78P in the large-diameter openings 71P, no non-connection occurs at the solder bumps 78S in the small-diameter openings 71S, allowing the connection reliability between the IC chip 90 and the multilayer printed wiring board 10 to be secured. Subsequently, it is attached to a daughter board 94 via solder bumps 78D (Fig. 12).

0050: In accordance with the first example, by the solder bumps having a high height 78S in the small-diameter openings 78S being flattened, the solder bumps 71S in the openings 71S with a varying diameter and the solder bumps 78P in the large-diameter openings 71P can be formed at roughly the same height. As such, when the IC chip 90 is loaded via the solder bumps 78S and the solder bumps 78P, the mounting yield of the IC chip can be enhanced and the securing of the connection reliability between the IC chip 90 and the multilayer printed wiring board 10 becomes possible.

0051: Further, in accordance with the first example, by the solder bumps for power supply and ground 78P in the large-diameter openings 71P being not flattened and being maintained semi-circle, voids are easily let out during reflow when the IC chip being loaded, preventing the occurrence of voids due to air inside the solder bumps not likely to result in high resistance, which makes it advantageous for power supply.

0052: And, according to the present example, with the loading cylinders 124 being positioned above the ball arrangement mask 16 the solder balls 77 are gathered by air being suctioned out of said loading cylinders 124 and the solder balls 77 gathered directly below the loading cylinders 124 are moved such that they are on the ball arrangement mask 16 by the loading cylinders 124 or the printed wiring board and the ball arrangement mask 16 being moved relative to each other and dropped into the small-diameter openings 71S and the large-diameter openings 71P of the multilayer printed wiring board 10 via the openings 16a of the ball arrangement mask 16. As such, it allows with certainty fine solder balls 77 to be loaded into all of the small-diameter openings 71S and large-diameter openings 71P of the multilayer printed wiring board 10. And, since the solder balls are moved while being in no-contact, the solder balls can be loaded into the small-diameter openings 71S and large-diameter openings 71P without being damaged, resulting in an even height of the solder bumps 78S, 78P, unlike the situation where a squeegee is used. Further, since the solder balls are guided by suction force, the aggregation and adhesion of solder balls can be prevented. Since they present themselves as solder bumps of a large volume having a uniform height, they present themselves as, not only having a high cold and heat shock resistance, low resistance solder bumps which are advantageous for power supply.

0053: In accordance with the first example, the height of small-diameter solder bumps 78S and the height of the large-diameter solder bumps 78S were set to the same 30 µm. The occurrence of non-connection bumps becomes difficult when it is set to no greater than 10 µm, which makes it easy to secure the connection reliability of solder bumps.

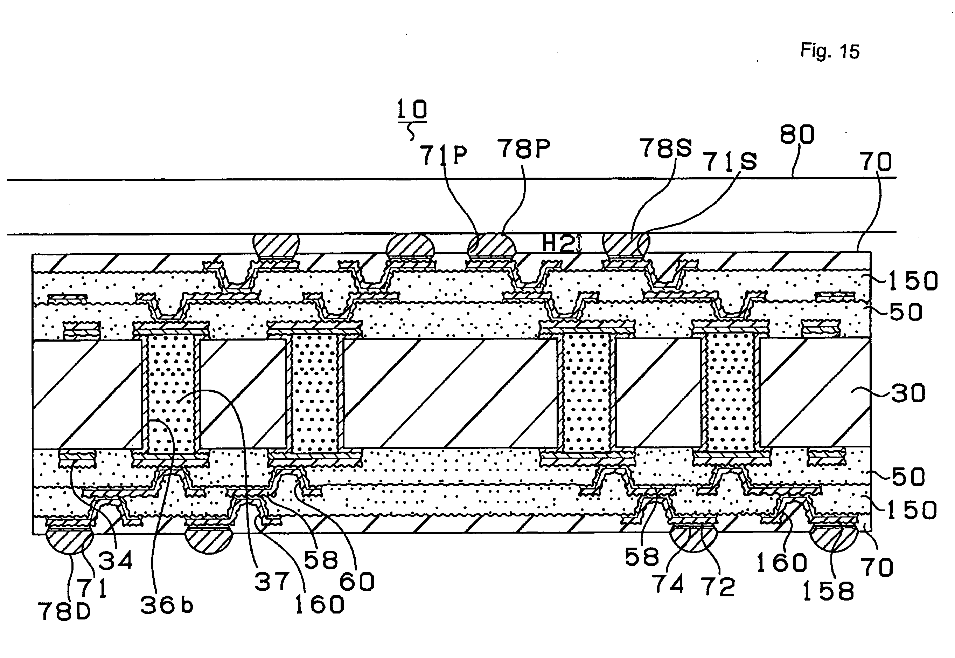

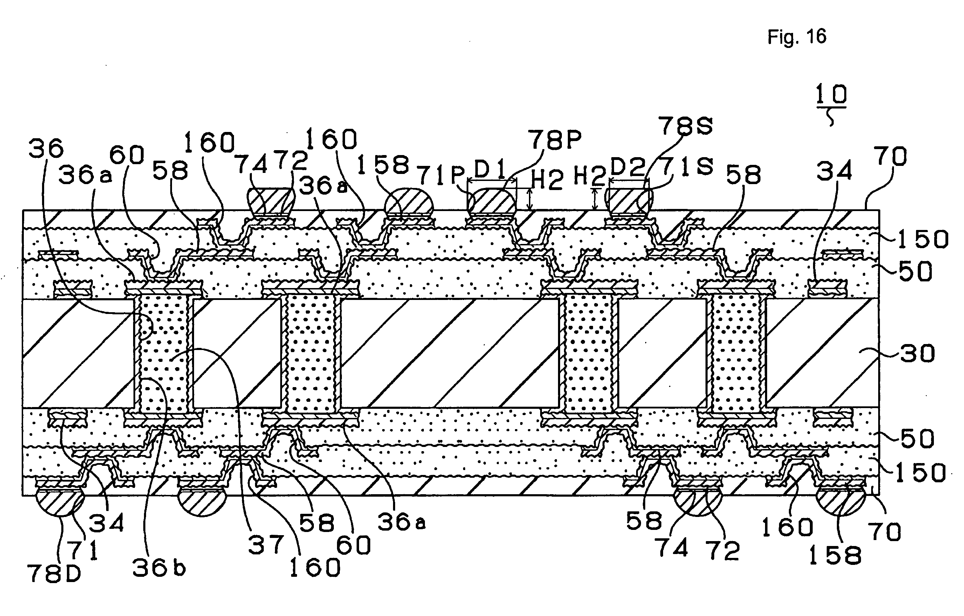

0054: The Second Example
Continuing on, a multilayer printed wiring board and a method of manufacturing the multilayer printed wiring board pertaining to the second example in accordance with the present invention will be described with reference to Fig. 15 and Fig. 16.
As described above with reference to Fig. 10 and Fig. 11, only the small-diameter solder bumps having a high height 78S were flattened. Contrary to this, in accordance with the second example, as illustrated in Fig. 15, by the large-diameter solder bumps having a low height 78P formed in the large-diameter (D1=105 µmM) openings 71P and the solder bumps 78S having a high height formed in the small-diameter (D2=80 µmM) openings 71S being pressed on with the flat plate 80, the solder bumps 78S having a high height in the small-diameter openings 71S and the solder bumps 78P in the large-diameter openings 71P are flattened such that the heights (H2®30 µm) are the same (Fig. 11). In addition, the solder bumps 78S and the solder bumps 78P are formed out of solder balls having the same diameter and have the same volume.

0055: Fig. 16, the solder bumps 78S in the small-diameter openings 71S which are flattened as a whole and the large-diameter 71S which are flattened at the top only are illustrated illustratively. In accordance with the second example, the advantage is that the height of all the solder bumps can be set uniformly.

### Brief Description of the Drawings:

0056:
Fig. 1: Step drawings illustrating a method of manufacturing a multilayer printed wiring board according to the first example of the present invention.
Fig. 2: Step drawings illustrating a method of manufacturing a multilayer printed wiring board according to the first example.
Fig. 3: Step drawings illustrating a method of manufacturing a multilayer printed wiring board according to the first example.
Fig. 4: Step drawings illustrating a method of manufacturing a multilayer printed wiring board according to the first example.
Fig. 5: Step drawings illustrating a method of manufacturing a multilayer printed wiring board according to the first example.
Fig. 6: Step drawings illustrating a method of manufacturing a multilayer printed wiring board according to the first example.
Fig. 7: Step drawings illustrating a method of manufacturing a multilayer printed wiring board according to the first example.
Fig. 8: Step drawings illustrating a method of manufacturing a multilayer printed wiring board according to the first example.
Fig. 9: A step drawing illustrating a method of manufacturing a multilayer printed wiring board according to the first example.
Fig. 10: A step drawing illustrating a method of manufacturing a multilayer printed wiring board according to the first example.
Fig. 11: A sectional view of a multilayer printed wiring board pertaining to the first example.
Fig. 12: A sectional view illustrating a condition in which an IC chip is placed on the multilayer printed wiring board illustrated in Fig. 11
Fig. 13: A plan view of a multilayer printed wiring board pertaining to the first example.
Fig. 14: Fig. 14 (A) is a structural view illustrating the structure of the solder ball loading apparatus pertaining to an example in accordance with the present invention, and Fig. 14 (B) is an arrow directional view of the solder ball loading apparatus in Fig. 14 (A) as viewed from the side of an arrow B.
Fig. 15: A step drawing illustrating a method of manufacturing a multilayer printed wiring board according to the second example of the present invention.
Fig. 16: A sectional view of a multilayer printed wiring board pertaining to the second example.
Fig. 17: Fig. 17 (A) an explanatory drawing illustrating solder bumps having differring diameters in accordance with the prior art, and Fig. 17 (B) an explanatory drawing illustrating solder bumps after reflow.

### 0057: Description of Reference Numerals:

- 30: Substrate
- 36: Through hole
- 40: Resin filled layer
- 50: Interlayer resin insulating layer
- 58: Conductor circuit
- 60: Via hole
- 70: Solder resist layer
- 71S: Small-diameter opening
- 71P: Large-diameter opening
- 77: Solder ball
- 78S: Small-diameter solder bump
- 78P: Large-diameter solder bump
- 100: Solder ball loading apparatus
- 124: Loading cylinder (cylinder member)

## Claims

1. A method of manufacturing a printed wiring board having bumps comprising at least the following steps (a) through (d):
(a) a step of forming a solder resist layer having small-diameter openings and large-diameter openings allowing connection pads to be exposed;
(b) a step of loading metal balls having a low melting point into said small-diameter openings and large-diameter openings with the use of a mask provided with opening portions corresponding to the small-diameter openings and large-diameter openings in the above-described solder resist layer;
(c) a step of forming by reflow bumps having a high height out of the metal balls having a low melting point in the above-described small-diameter openings and bumps having a low height out of the metal balls having a low melting point in the above-described large-diameter openings; and
(d) a step of pressing from the top on the bumps having a high height in the above-described small-diameter openings such that it is nearly the same height as that of the bumps having a low height in the above-described large-diameter openings.

2. As to the above-described step (b),
the method of manufacturing the printed wiring board as set forth in claim 1, wherein the above-described metal balls having a low melting point are gathered with a cylinder member provided with openings facing said mask being positioned above said mask and air being sucked out with said cylinder member, and the above-described metal balls having a low melting point gathered directly below the above-described cylinder member by the above-described cylinder member or the printed wiring board and the mask being moved relative to each other in a horizontal direction are dropped into the small-diameter openings and the large-diameter openings of the above-described solder resist layer via the opening portions of the above-described mask.

3. As to a multilayer printed wiring board wherein on a core substrate having through-hole conductors penetrating the front face and the rear face there are alternately laminated interlayer resin insulating layers and conductor layers, via-hole conductors connect a conductor layer to anther conductor layer, a solder resist layer is provided on the outermost layer, a portion of the conductor layer exposed from an opening in said solder resist layer constitutes a pad to mount an electronic part, and solder bumps are formed on said pads,
a printed wiring board wherein:
the above-described openings are made up with small-diameter openings having a relatively small diameter and large-diameter openings having a relatively large diameter; and
the solder bumps formed in the above-described small-diameter openings and in the above-described large-diameter openings having the same volume and the solder bumps formed in said small-diameter openings and the solder bumps formed in the above-described large-diameter openings are adjusted such that they are approximated to each other by the solder bumps formed in the above-described small-diameter openings being flattened.

4. A printed wiring board as set forth in claim 3, wherein:
the above-described large-diameter openings are mainly disposed on the center side of the printed wiring board; and
the above-described small-diameter openings are mainly disposed on the outer side of the above-described large-diameter openings being on the center side.

5. A printed wiring board as set forth in claim 3 or claim 4, wherein:
the difference in height between the solder bumps formed in the above-described small-diameter openings and the solder bumps formed in the above-described large-diameter openings is no greater than 10 µm.
